(19) Europäisches Patentamt
European Patent Office
Office européen des brevets

(11) **EP 4 395 506 A1**

(12) **EUROPEAN PATENT APPLICATION**

(43) Date of publication:
**03.07.2024 Bulletin 2024/27**

(21) Application number: **23199398.1**

(22) Date of filing: **25.09.2023**

(51) International Patent Classification (IPC):
*H10K 59/122* (2023.01)      *H10K 59/124* (2023.01)
*H10K 59/80* (2023.01)

(52) Cooperative Patent Classification (CPC):
**H10K 59/122; H10K 59/124; H10K 59/80523;
H10K 59/878; H10K 59/879**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.12.2022 KR 20220190860**

(71) Applicant: **LG Display Co., Ltd.
Seoul 07336 (KR)**

(72) Inventors:
• **Yu, Hyeonhye
10845 Paju-si (KR)**

• **Park, SeHong
10845 Paju-si (KR)**
• **Kim, Wonrae
10845 Paju-si (KR)**
• **Park, Hyemin
10845 Paju-si (KR)**
• **Seong, Sejong
10845 Paju-si (KR)**

(74) Representative: **Ter Meer Steinmeister & Partner
Patentanwälte mbB
Nymphenburger Straße 4
80335 München (DE)**

(54) **DISPLAY APPARATUS**

(57)      A display apparatus is provided, which may improve light extraction efficiency of light emitted from a light emitting element layer. The display apparatus comprises a substrate having a plurality of pixels having a plurality of subpixels, a pattern portion disposed on the substrate and formed to be concave between the plurality of subpixels, and a reflective portion disposed to be inclined on the pattern portion, wherein the plurality of subpixels include a first layer adjacent to the reflective portion on the substrate, including a plurality of concave portions, and a second layer on the first layer, and an inclination angle $\theta$ of the reflective portion is provided to satisfy

$$\text{Taper Angle}(\theta) = \frac{180 \times \log\sqrt{0.11 \times T_L^2 + T_H^2}}{\pi}$$

, where $T_H$ is a maximum thickness of the second layer in the concave portion, $T_L$ is a thickness of the first layer on an extension line of $T_H$, and $\pi$ is a circular constant.

EP 4 395 506 A1

**Description**

This application claims the benefit of the Korean Patent Application No. 10-2022-0190860 filed on December 30, 2022.

BACKGROUND

Field of the Invention

The present disclosure relates to a display apparatus for displaying an image.

Description of the Related Art

Since an organic light emitting display apparatus has a high response speed and low power consumption and self-emits light without requiring a separate light source unlike a liquid crystal display apparatus, there is no problem in a viewing angle and thus the organic light emitting display apparatus has received attention as a next-generation flat panel display apparatus.

Such a display apparatus displays an image through light emission of a light emitting element layer that includes a light emitting layer interposed between two electrodes.

Meanwhile, light extraction efficiency of the display apparatus is reduced as some of light emitted from the light emitting element layer is not emitted to the outside due to total reflection on the interface between the light emitting element layer and an electrode and/or between a substrate and an air layer.

SUMMARY

The present disclosure has been made in view of the above problems and it is an object of the present disclosure to provide a display apparatus that may improve light extraction efficiency of light emitted from a light emitting element layer.

It is hence an object of the present disclosure to provide a display apparatus that may further improve light extraction efficiency of light emitted from a light emitting element layer.

It is other object of the present disclosure to provide a display apparatus that may reduce overall power consumption.

In addition to the objects of the present disclosure as mentioned above, additional objects and features of the present disclosure will be clearly understood by those skilled in the art from the following description of the present disclosure.

According to the present disclosure, light extraction efficiency and/or power consumption of a display apparatus may be improved and/or power consumption of a display apparatus may be reduced through light extraction from a non-light emission area.

In accordance with an aspect of the present disclosure, a display apparatus comprises a substrate having a plurality of pixels having a plurality of subpixels, a pattern portion disposed on the substrate and formed to be concave between the plurality of subpixels, and a reflective portion disposed to be inclined on the pattern portion, wherein the plurality of subpixels include a first layer adjacent to the reflective portion on the substrate, including a plurality of concave portions, and a second layer on the first layer, and an inclination angle θ of the reflective portion is provided to satisfy

$$\text{Taper Angle}(\theta) = \frac{180 \times \log \sqrt{0.11 \times T_L^2 + T_H^2}}{\pi}$$

, where $T_H$ is a maximum thickness of the second layer in the concave portion, $T_L$ is a thickness of the first layer on an extension line of $T_H$, and $\pi$ is a circular constant.

In accordance with another aspect of the present disclosure, a display apparatus comprises a substrate having a plurality of pixels having a plurality of subpixels, a pattern portion disposed on the substrate and formed to be concave between the plurality of subpixels, and a reflective portion disposed to be inclined on the pattern portion, wherein the plurality of subpixels include a first layer adjacent to the reflective portion on the substrate, including a plurality of concave portions, and a second layer on the first layer, and an inclination angle of the reflective portion is a function of a maximum thickness of the second layer and a thickness of the first layer in the concave portion.

In accordance with another aspect of the present disclosure, a display apparatus comprises: a substrate having a plurality of subpixels, each subpixel including a light emission area and a non-light emission area; an overcoat layer disposed on the substrate, the overcoat layer including a first layer and a second layer disposed on the first layer; a pattern portion formed in the first layer in the non-light emission area to be concave, the pattern portion including an inclined surface; and a reflective portion disposed on the pattern portion in the non-light emission area and including an inclined reflective surface on the inclined surface of the pattern portion; wherein the first layer includes a plurality of concave portions in the light emission area, the concave portions being filled and/or covered by the second layer, and wherein an inclination angle $\theta$ of the reflective portion is a function of a maximum thickness $T_H$ of the second layer and a thickness $T_L$ of the first layer (along a center line of one of the concave portions or along an extension line of the maximum thickness $T_H$ of the second layer).

The display apparatus according to any one of these aspects may include one or more of the following features:

Each subpixel may include a light emission area and a non-light emission area. The pattern portion may be a (surface) portion of the first layer in the non-light emission area. The pattern portion may be formed in the first layer in the non-light emission area to be concave between light emission areas of adjacent subpixels. The pattern portion may include an inclined surface and/or a bottom surface. The bottom surface may be parallel to a surface of the substrate. The inclined surface may be inclined with respect to the bottom surface, i.e. form an angle therewith (e.g. an angle of 180°- $\theta$). The inclined surface may be covered by a bank. The first layer may include a plurality of concave portions in the light emission area. Here, concave may refer to a top view on an upper surface of the first layer.

The second layer may be formed on the first layer at least in a light emission area to cover and/or fill the concave portion. In other words, the second layer may planarize the concave portions, i.e. the light extraction portion including the plurality of concave portions. The second layer may extend into the non-light emission area to cover the inclined surface of the pattern portion and/or the inclined surface of the reflective portion. The center line of the concave portion may be perpendicular to the substrate and/or to an upper surface of the second layer and/or to an upper surface of the reflective electrode in the light emission area. The center line may pass through a center of the concave portion in a top view of an upper surface of the second layer.

Each subpixel may include a light emitting element layer including a reflective electrode. The reflective portion may be a portion of the reflective electrode in the non-light emission area. The reflective portion may include an inclined (reflective) surface disposed on or overlapping with the inclined surface of the pattern portion and/or a flat (reflective) surface disposed on or overlapping with the bottom surface of the pattern portion. The inclined (reflective) surface of the reflective portion may extend parallel to the inclined surface of the pattern portion.

A thickness of a layer may refer to a dimension thereof in a direction perpendicular to the substrate.

The inclination angle of the reflective portion (i.e. of the inclined reflective surface) may be a crossing angle between an upper surface of the substrate and the reflective portion on the pattern portion. The inclination angle of the reflective portion (i.e. of the inclined reflective surface) may be a crossing angle between an upper surface of the substrate and the reflective portion on the pattern portion. The inclination angle of the reflective portion (i.e. of the inclined reflective surface) may be in a range from 40° to 75°. The inclination angle of the reflective portion may be an angle between the reflective portion (i.e. of the inclined reflective surface) disposed in the non-light emission area and an extension line of a lower surface of the reflective electrode in the light emission area.

The plurality of concave portions may overlap the light emission area of each of the plurality of subpixels. The non-light emission area may include a first area adjacent to the light emission area and a second area adjacent to the first area and spaced apart from the light emission area. The concave portions may be disposed to be adjacent to the pattern portion.

The pattern portion may surround the light emission area. The pattern portion may be disposed to be spaced apart from the light emission area. The non-light emission area may include a first area adjacent to the light emission area and a second area adjacent to the first area and spaced apart from the light emission area. The pattern portion may include an inclined surface formed in the first area and a bottom surface extended from the inclined surface and formed up to the second area.

A width of the pattern portion may be reduced in a direction directed toward the substrate from the reflective portion.

A light emitting element layer may be provided in the plurality of subpixels. The light emitting element layer may include a pixel electrode in the light emission area; a light emitting layer on the pixel electrode and the non-light emission area; and a reflective electrode on the light emitting layer. The reflective portion may be a portion of the reflective electrode.

The plurality of subpixels may include a light emission area, a non-light emission area adjacent to the light emission area, and a reflective electrode arranged in the light emission area and the non-light emission area. The reflective portion may be a portion of the reflective electrode.

The plurality of subpixels may include a light emission area and a non-light emission area adjacent to the light emission area. The reflective electrode may be disposed in the light emission area and the non-light emission area. An inclination angle of the reflective portion may be a crossing angle between an extension line of a lower surface of the reflective electrode in the light emission area and the reflective portion arranged in the non-light emission area.

A value obtained by summing $T_H$ and $T_L$ is 2 $\mu$m to 7 $\mu$m. A radius of each of the concave portions or $T_L$ may be 1 µm or more.

The inclination angle θ of the reflective portion (i.e. of the inclined reflective surface) may be proportional to or a function of an aspect ratio of each of the concave portions. The thickness $T_H$ of the second layer may be a value obtained by multiplying an aspect ratio of each of the concave portions and a radius of each of the concave portion.

An aspect ratio of each of the concave portions may exceed 0 and may be 1 or less. The concave portions may thus have a bowl like or flattened shape.

The non-light emission area may include a first area adjacent to the light emission area and a second area adjacent to the first area and/or spaced apart from the light emission area (i.e. by the first area). The concave portions may be disposed to be adjacent to the pattern portion. The pattern portion may include an inclined surface formed in the first area and a bottom surface extended from the inclined surface and/or formed up to the second area.

The second layer may be disposed between the first layer and the pixel electrode, e.g. in the light emission area. The second layer may extend to the first area and/or may be in contact with a portion of the bottom surface of the pattern portion while covering the inclined surface of the pattern portion.

The inclined surface of the pattern portion may form an obtuse angle with respect to the bottom surface and/or to the substrate.

A bank may be provided to cover an edge of the pixel electrode. The bank may cover the second layer covering the inclined surface and/or may be in contact with a portion of the bottom surface of the pattern portion.

Each of the second layer and the bank may be discontinuous, e.g. on the substrate. Each of the second layer and the bank on the bottom surface of the pattern portion may be discontinuous.

BRIEF DESCRIPTION OF THE DRAWINGS

The above and other objects, features and other advantages of the present disclosure will be more clearly understood from the following detailed description taken in conjunction with the accompanying drawings, in which:

FIG. 1 is a schematic plan view illustrating a display apparatus according to one embodiment of the present disclosure;
FIG. 2 is a schematic cross-sectional view taken along line I-I shown in FIG. 1;
FIG. 3 is an enlarged view illustrating a portion A of FIG. 2;
FIG. 4a is a comparative example illustrating that an aspect ratio of a concave portion exceeds 1;
FIG. 4b is a view illustrating that an aspect ratio of a concave portion of a display apparatus according to one embodiment of the present disclosure exceeds 0 and is less than 1;
FIG. 5 is a light efficiency map illustrating a refractive index of a concave portion with respect to an aspect ratio of the concave portion of a display apparatus according to one embodiment of the present disclosure; and
FIG. 6 is a graph illustrating light efficiency with respect to a refractive index of a first layer of a display apparatus according to one embodiment of the present disclosure.

DETAILED DESCRIPTION OF THE DISCLOSURE

Reference will now be made in detail to the embodiments of the present disclosure, examples of which are illustrated in the accompanying drawings. Wherever possible, the same reference numbers will be used throughout the drawings to refer to the same or like parts. Advantages and features of the present disclosure, and implementation methods thereof will be clarified through following embodiments described with reference to the accompanying drawings.

The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art.

A shape, a size, a ratio, an angle, and a number disclosed in the drawings for describing embodiments of the present disclosure are merely an example, and thus, the present disclosure is not limited to the illustrated details.

Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description. In describing a position relationship, for example, when a position relation between two parts is described as 'on~', 'over~', 'under~', and 'next~', one or more other parts may be disposed between the two parts unless 'just' or 'direct' is used.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms.

These terms are only used to distinguish one element from another. For example, a first element could be termed a second element, and, similarly, a second element could be termed a first element, without departing from the scope of the present disclosure.

"X-axis direction", "Y-axis direction" and "Z-axis direction" should not be construed by a geometric relation only of a mutual vertical relation and may have broader directionality within the range that elements of the present disclosure may act functionally.

The term "at least one" should be understood as including any and all combinations of one or more of the associated listed items. For example, the meaning of "at least one of a first item, a second item and a third item" denotes the combination of all items proposed from two or more of the first item, the second item and the third item as well as the first item, the second item or the third item.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in co-dependent relationship.

Hereinafter, the preferred embodiments of the present disclosure will be described in detail with reference to the accompanying drawings.

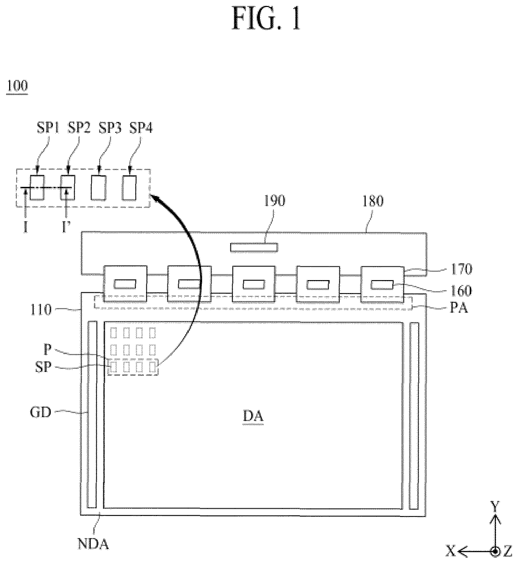

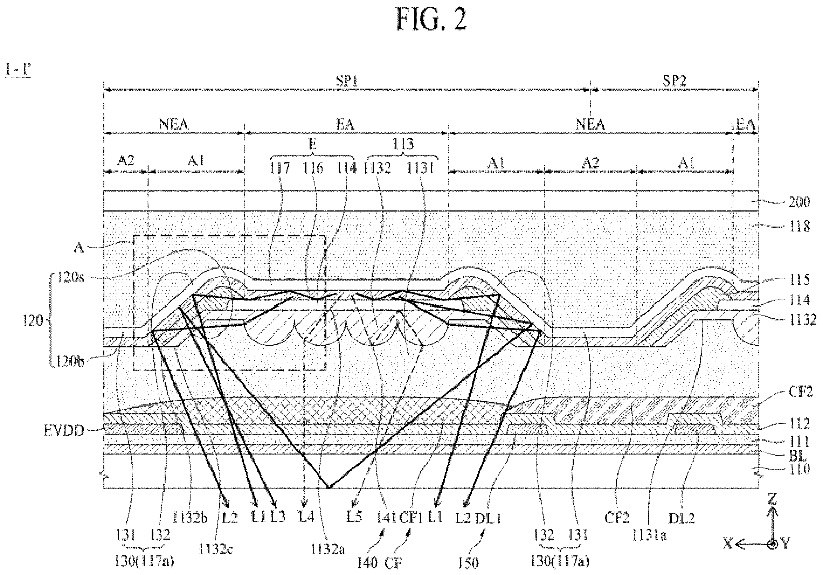

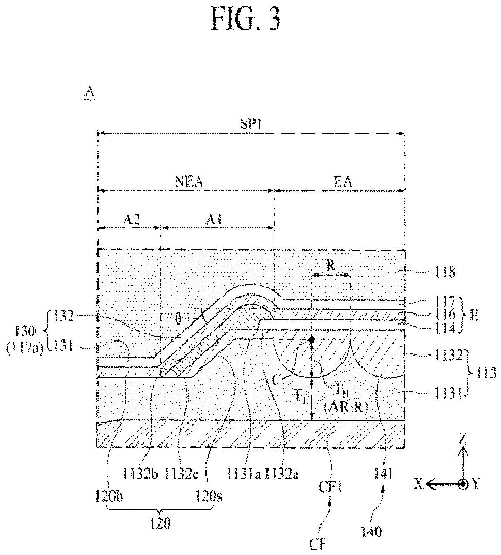

FIG. 1 is a schematic plan view illustrating a display apparatus according to one embodiment of the present disclosure, FIG. 2 is a schematic cross-sectional view taken along line I-I shown in FIG. 1, and FIG. 3 is an enlarged view illustrating a portion A of FIG. 2.

Referring to FIGS. 1 to 3, a display apparatus 100 according to one embodiment of the present disclosure includes a substrate 110 having a plurality of pixels P having a plurality of subpixels SP, a pattern portion 120 disposed on the substrate 110 and formed to be concave between the plurality of subpixels SP, and a reflective portion 130 disposed to be inclined on the pattern portion 120.

The plurality of subpixels SP may include a first layer 1131 adjacent to the reflective portion 130 on the substrate 110, including a plurality of concave portions 141 and a second layer 1132 on the first layer 1131. As shown in FIGS. 2 and 3, since the plurality of concave portions 141 may be provided in the form of a parabola, the plurality of concave portions 141 may be expressed as terms such as a parabolic or parabolic structure. An inclination angle θ of the reflective

$$\text{Taper Angle}(\theta) = \frac{180 \times \log \sqrt{0.11 \times T_L^2 + T_H^2}}{\pi}$$

portion 130 may be provided to satisfy . The inclination angle of the reflective portion 130 may be a crossing angle between the upper surface of the substrate 110 and the reflective portion 130 on the pattern portion 120. Alternatively, as shown in FIG. 3, the inclination angle of the reflective portion 130 may be a crossing angle between an extension line of a lower surface of a reflective electrode 117 in the light emission area EA of the plurality of subpixels SP and the reflective portion 130 disposed in the non-light emission area NEA, which is adjacent to the light emission area EA. As shown in FIG. 3, $T_H$ may be a maximum thickness of the second layer 1132 in the concave portion 141. $T_L$ may be a thickness of the first layer 1131 on an extension line of $T_H$. $\pi$ may be a circular constant. $T_H$ and $T_L$ may respectively represent a thickness of the second layer 1132 and a thickness of the first layer 1131 in a direction parallel with a third direction (Z-axis direction).

In the display apparatus 100 according to one embodiment of the present disclosure, the inclination angle θ of the reflective portion 130 may be a function of the maximum thickness $T_H$ of the second layer 1132 and the thickness $T_L$ of the first layer 1131 in the concave portion 141. Therefore, in the display apparatus 100 according to one embodiment of the present disclosure, as the reflective portion 130 disposed in the non-light emission area NEA may be provided at an optimal angle, light extraction efficiency for light emitted from the light emission area EA and directed toward an adjacent sub pixel SP may be improved, whereby overall light efficiency may be improved.

Hereinafter, reference to FIGS. 1 to 3, the display apparatus 100 according to an embodiment of the present specification will be described in more detail.

Each of the plurality of subpixels SP according to one embodiment may include a light emission area EA, a non-light emission area NEA adjacent to the light emission area EA and a light extraction portion 140 that overlaps the light emission area EA and includes a plurality of concave portions 141. The light emission area EA is an area from which light is emitted, and may be included in the display area DA. The non-light emission area NEA is an area from which light is not emitted, and may be an area adjacent to the light emission area EA. The non-light emission area NEA may be referred to as a term of a peripheral area. The reflective portion 130 may be adjacent to the light extraction portion 140 in the non-light emission area NEA, and may be spaced apart from the light emission area EA.

Therefore, in the display apparatus 100 according to one embodiment of the present disclosure, since the reflective portion 130 disposed in the non-light emission area NEA may reflect light, which is directed toward the subpixel adjacent thereto among light emitted from the light emission area EA, toward the subpixel SP for emitting light, light efficiency (or light extraction efficiency) of the subpixel SP for emitting light may be improved.

The reflective portion 130 according to one embodiment may be provided to be inclined on the pattern portion 120 in the non-light emission area NEA. When the inclination angle $\theta$ of the reflective portion 130 disposed to be inclined is too small, reflectance of the light directed toward the adjacent subpixel SP is reduced, whereby light extraction efficiency may be reduced. On the contrary, when the inclination angle $\theta$ of the reflective portion 130 disposed to be inclined is too large, reflectance of the light directed toward the adjacent subpixel SP is increased. However, as the reflective portion 130 is positioned to be too close to a line for driving the pixel, parasitic capacitance may be generated. When parasitic capacitance is generated, a signal for driving the pixel P may be delayed.

For example, the inclination angle $\theta$ of the reflective portion 130 may be 40° to 75°. As described above, when the inclination angle $\theta$ of the reflective portion 130 is less than 40°, reflectance of light by the reflective portion 130 may be reduced, whereby light efficiency may be deteriorated. In contrast, when the inclination angle $\theta$ of the reflective portion 130 exceeds 75°, the reflective portion 130 on the pattern portion 120 becomes close to the line, whereby parasitic capacitance is generated and thus the signal may be delayed.

Therefore, in the display apparatus 100 according to one embodiment of the present disclosure, as the inclination angle $\theta$ of the reflective portion 130 disposed in the non-light emission area NEA is provided at an optimal angle of 40° to 75°, occurrence of parasitic capacitance may be avoided and light extraction efficiency for the light emitted from the light emission area EA and directed toward the adjacent subpixel SP may be improved.

The inclination angle $\theta$ of the reflective portion 130 may be derived by an equation related to the maximum thickness $T_H$ of the second layer 1132 and the thickness $T_L$ of the first layer 1131 in the concave portion 141. This will be described later.

The non-light emission area NEA according to one example may include a first area A1 adjacent to the light emission area EA and a second area A2 adjacent to the first area A1 and spaced apart from the light emission area EA. The first area A1 according to one example may be a bank area in which a bank (or a bank covering an edge of the pixel electrode) defining the light emission area EA is disposed. The second area A2 according to one example may be a bank-less area in which a bank is not disposed.

The pattern portion 120 according to one example may be formed to be concave in the non-light emission area NEA. For example, the pattern portion 120 may be formed to be concave in an overcoat layer 113 (shown in FIG. 2) on the substrate 110. The pattern portion 120 may be disposed to be spaced apart from the light emission area EA. The pattern portion 120 according to one example may be provided to surround the light emission area EA in the form of a slit or a trench. For example, a width of the pattern portion 120 may be formed to be reduced from the reflective portion 130 toward the substrate 110. Also, as shown in FIG. 2, the pattern portion 120 may include an area exposed without being covered by the bank 115. Therefore, the pattern portion 120 may be expressed as terms such as a groove, a slit, a trench, a bank slit and a bank trench. As shown in FIG. 2, the pattern portion 120 may include an inclined surface 120s formed in the first area A1 and a bottom surface 120b extending from the inclined surface 120s to the second area A2. The pattern portion 120 may be a surface portion of the first layer 1131 in the non-light emission area NEA and may include the inclined surface 120s and the bottom surface 120b. The bottom surface 120b may be parallel to a surface of the substrate 110. The inclined surface 120s may be inclined with respect to the bottom surface 120b, i.e. form an angle therewith (e.g. an angle of 180°- $\theta$). The inclined surface 120s may be covered by a bank 115.

The reflective portion 130 according to one example may be formed to be concave along a profile of the pattern portion 120 formed to be concave the non-light emission area NEA, thereby being formed to be concave the non-light emission area NEA. The reflective portion 130 may be made of a material capable of reflecting light, and may reflect light, which is emitted from the light emission area EA and directed toward the adjacent subpixel SP, toward the light emission area EA for emitting light. As shown in FIG. 2, since the reflective portion 130 is disposed to be inclined on the pattern portion 120 while surrounding the light emission area EA, the reflective portion 130 may be expressed as terms such as a side reflective portion or an inclined reflective portion.

Meanwhile, the display apparatus 100 according to one embodiment of the present disclosure may be implemented in a bottom emission type in which light emitted from the light emission area EA is emitted to the lower surface of the substrate 110. Therefore, in the display apparatus 100 according to one embodiment of the present disclosure, the light emitted to the lower surface of the substrate 110 may be the light in which direct light emitted from the light emission area EA and directly emitted to the lower surface of the substrate 110 and reflective light obtained by reflecting the light, which is emitted from the light emission area EA and directed toward the adjacent subpixel SP, by the reflective portion 130 and emitting the light to the lower surface of the substrate 110 are combined with each other. Therefore, the display apparatus 100 according to one embodiment of the present disclosure may more improve light extraction efficiency than the display apparatus in which the reflective portion 130 formed to be concave is not provided.

Referring to FIGS. 1 and 2, the display apparatus 100 according to one embodiment of the present disclosure may include a display panel having a gate driver GD, a light extraction portion 140 overlapping a light emission area EA, a plurality of lines 150, a source drive integrated circuit (hereinafter, referred to as "IC") 160, a flexible film 170, a circuit board 180, and a timing controller 190.

The display panel may include a substrate 110 and an opposite substrate 200 (shown in FIG. 2).

The substrate 110 may include a thin film transistor, and may be a transistor array substrate, a lower substrate, a base substrate, or a first substrate. The substrate 110 may be a transparent glass substrate or a transparent plastic substrate. The substrate 110 may include a display area DA and a non-display area NDA.

The display area DA is an area where an image is displayed, and may be a pixel array area, an active area, a pixel array unit, a display unit, or a screen. For example, the display area DA may be disposed at a central portion of the display panel. The display area DA may include a plurality of pixels P.

The opposite substrate 200 may encapsulate (or seal) the display area DA disposed on the substrate 110. For example, the opposite substrate 200 may be bonded to the substrate 110 via an adhesive member (or clear glue). The opposite substrate 200 may be an upper substrate, a second substrate, or an encapsulation substrate.

The gate driver GD supplies gate signals to the gate lines in accordance with the gate control signal input from the timing controller 190. The gate driver GD may be formed on one side of the light emission area EA or in the non-light emission area NEA outside both sides of the light emission area EA in a gate driver in panel (GIP) method, as shown in FIG. 1.

The non-display area NDA is an area on which an image is not displayed, and may be a peripheral area, a signal supply area, an inactive area or a bezel area. The non-display area NDA may be configured to be in the vicinity of the display area DA. That is, the non-display area NDA may be disposed to surround the display area DA.

A pad area PA may be disposed in the non-display area NDA. The pad area PA may supply a power source and/or a signal for outputting an image to the pixel P provided in the display area DA. Referring to FIG. 1, the pad area PA may be provided above the display area DA.

The source drive IC 160 receives digital video data and a source control signal from the timing controller 190. The source drive IC 160 converts the digital video data into analog data voltages in accordance with the source control signal and supplies the analog data voltages to the data lines. When the source drive IC 160 is manufactured as a driving chip, the source drive IC 160 may be packaged in the flexible film 170 in a chip on film (COF) method or a chip on plastic (COP) method.

Pads, such as data pads, may be formed in the non-display area NDA of the display panel. Lines connecting the pads with the source drive IC 160 and lines connecting the pads with lines of the circuit board 180 may be formed in the flexible film 170. The flexible film 170 may be attached onto the pads by using an anisotropic conducting film, whereby the pads may be connected with the lines of the flexible film 170.

The circuit board 180 may be attached to the flexible films 170. A plurality of circuits implemented as driving chips may be packaged in the circuit board 180. For example, the timing controller 190 may be packaged in the circuit board 180. The circuit board 180 may be a printed circuit board or a flexible printed circuit board.

The timing controller 190 receives the digital video data and a timing signal from an external system board through a cable of the circuit board 180. The timing controller 190 generates a gate control signal for controlling an operation timing of the gate driver GD and a source control signal for controlling the source drive ICs 160 based on the timing signal. The timing controller 190 supplies the gate control signal to the gate driver GD, and supplies the source control signal to the source drive ICs 160.

Referring to FIG. 2, the substrate 110 according to an example may include the light emission area EA and the non-light emission area NEA.

The light emission area EA is an area from which light is emitted, and may mean an area that is not covered by a bank 115. A light emitting element layer E, which includes a pixel electrode 114, a light emitting layer 116 and a reflective electrode 117, may be disposed in the light emission area EA. When an electric field is formed between the pixel electrode 114 and the reflective electrode 117, the light emitting layer 116 in the light emission area EA may emit light.

The light emission area EA according to an example may include gate lines, data lines, pixel driving power lines, and a plurality of pixels P. Each of the plurality of pixels P may include a plurality of subpixels SP that may be defined by the gate lines and the data lines.

Meanwhile, at least four subpixels, which are provided to emit different colors and disposed to be adjacent to one another, among the plurality of subpixels SP may constitute one pixel P (or unit pixel). One pixel P may include, but is not limited to, a red subpixel, a green subpixel, a blue subpixel and a white subpixel. One pixel P may include three subpixels SP provided to emit light of different colors and disposed to be adjacent to one another. For example, one pixel P may include a red subpixel, a green subpixel and a blue subpixel.

Each of the plurality of subpixels SP includes a thin film transistor and a light emitting element layer E connected to the thin film transistor. Each of the plurality of subpixels may include a light emitting layer (or an organic light emitting layer) interposed between the pixel electrode and the reflective electrode.

The light emitting layer respectively disposed in the plurality of subpixels SP may individually emit light of different colors or emit white light in common. Since the light emitting layer of each of the plurality of subpixels SP commonly emit white light, each of the red subpixel, the green subpixel and the blue subpixel may include a color filter CF (or wavelength conversion member CF) for converting white light into light of its respective different color. In this case, the white subpixel may not include a color filter.

In the display apparatus 100 according to one embodiment of the present disclosure, an area provided with a red color filter may be a red subpixel or a first subpixel, an area provided with a green color filter may be a green subpixel or a second subpixel, an area provided with a blue color filter may be a blue subpixel or a third subpixel, and an area in which the color filter is not provided may be a white subpixel or a fourth subpixel.

Each of the subpixels SP supplies a predetermined current to the organic light emitting element in accordance with a data voltage of the data line when a gate signal is input from the gate line by using the thin film transistor. For this reason, the light emitting layer of each of the subpixels may emit light with a predetermined brightness in accordance with the predetermined current.

The plurality of subpixels SP according to one example may be disposed to be adjacent to each other in a first direction (X-axis direction). The first direction (X-axis direction) may be a horizontal direction based on FIG. 1. The horizontal direction may be a direction in which a gate line is disposed.

A second direction (Y-axis direction) is a direction crossing the first direction (X-axis direction), and may be a vertical direction based on FIG. 1. The vertical direction may be a direction in which a data line is disposed.

A third direction (Z-axis direction) is a direction crossing each of the first direction (X-axis direction) and the second direction (Y-axis direction), and may be a thickness direction of the display apparatus 100.

The plurality of subpixels SP may include a first subpixel SP1, a second subpixel SP2, a third subpixel SP3 and a fourth subpixel SP4 arranged adjacent to each other in the first direction (X-axis direction). For example, the first subpixel SP1 may be a red subpixel, the second subpixel SP2 may be a green subpixel, the third subpixel SP3 may be a blue subpixel and the fourth subpixel SP4 may be a white subpixel, but is not limited thereto. However, the arrangement order of the first subpixel SP1, the second subpixel SP2, the third subpixel SP3 and the fourth subpixel SP4 may be changed.

Each of the first to fourth subpixels SP1 to SP4 may include a light emission area EA and a circuit area. The light emission area EA may be disposed at one side (or an upper side) of a subpixel area, and the circuit area may be disposed at the other side (or a lower side) of the subpixel area. For example, the circuit area may be disposed at the lower side of the light emission area EA based on the second direction Y. The light emission areas EA of the first to fourth subpixels SP1 to SP4 may have same sizes (or areas) as each other, or different sizes (or areas) as each other.

The first to fourth subpixels SP1 to SP4 may be disposed to be adjacent to one another along the first direction (X-axis direction). For example, two data lines extended along the second direction (Y-axis direction) may be disposed in parallel with each other between the first subpixel SP1 and the second subpixel SP2 and between the third subpixel SP3 and the fourth subpixel SP4. A pixel power line extended along the first direction (X-axis direction) may be disposed between the light emission area EA and the circuit area of each of the first to fourth subpixels SP1 to SP4. The gate line and a sensing line may be disposed below the circuit area. The pixel power line EVDD (shown in FIG. 2) extended along the second direction (Y-axis direction) may be disposed at one side of the first subpixel SP1 or the fourth subpixel SP4. A reference line extended along the second direction (Y-axis direction) may be disposed between the second subpixel SP2 and the third subpixel SP3. The reference line may be used as a sensing line for sensing a change of characteristics of a driving thin film transistor and/or a change of characteristics of the light emitting element layer, which is disposed in the circuit area, from the outside in a sensing driving mode of the pixel P. The data lines, the pixel power line EVDD and the reference line may be included in the plurality of lines 150. The data lines may include a first data line DL1 for driving the first subpixel SP1, a second data line DL2 for driving the second subpixel SP2, a third data line for driving the third subpixel SP3 and a fourth data line for driving the fourth subpixel SP4.

A plurality of lines 150 may be provided below the pattern portion 120. Each of the plurality of lines 150 may at least partially overlap the pattern portion 120 below the pattern portion 120. For example, as shown in FIG. 2, the first data line DL1 may partially overlap the bottom surface 120b of the pattern portion 120 between the first subpixel SP1 and the second subpixel SP2. The second data line DL2 may partially overlap the inclined surface 120s of the pattern portion 120. The pixel power line EVDD or the reference line may partially overlap the bottom surface 120b and the inclined surface 120s of the pattern portion 120.

In the display apparatus 100 according to one embodiment of the present disclosure, each of the plurality of subpixels SP may include the light extraction portion 140. The light extraction portion 140 may be formed on the overcoat layer 113 (shown in FIG. 2) to overlap the light emission area EA of the subpixel. The light extraction portion 140 may be formed on the overcoat layer 113 of the light emission area EA to have a curved (or uneven) shape, thereby changing a propagation path of light emitted from the light emitting element layer E to increase light extraction efficiency. For example, the light extraction portion 140 may be a non-flat portion, an uneven pattern portion, a micro lens portion, or a light scattering pattern portion.

The light extraction portion 140 may include a plurality of concave portions 141. The plurality of concave portions 141 may be formed to be concave inside the overcoat layer 113. For example, the plurality of concave portions 141 may be formed or configured to be concave from an upper surface 1131a of a first layer 1131 included in the overcoat layer 113. Therefore, the first layer 1131 may include a plurality of concave portions 141. The first layer 1131 may be disposed between the substrate 110 and the light emitting element layer E in the third direction (Z-axis direction). The concave portions 141 may be disposed adjacent to the pattern portion 120 in the first direction (X-axis direction).

A second layer 1132 of the overcoat layer 113 may be disposed between the first layer 1131 and a light emitting element layer E (or a pixel electrode 114 shown in FIG. 2). The second layer 1132 according to one example may be formed to be wider than the pixel electrode 114 in a first direction (X-axis direction). Thus, a portion of the second layer 1132 may overlap the light emissive area EA, and the other portion of the second layer 1132 may be in contact with a portion of the bottom surface 120b while covering the inclined surface 120s of the pattern portion 120. That is, as shown in FIG. 2, the second layer 1132 may be extended from the light emission area EA to the first area A1 and thus may be in contact with a portion of the bottom surface 120b while covering the inclined surface 120s of the pattern portion 120. Since an upper surface 1132a of the second layer 1132 is provided flat, the pixel electrode 114 disposed on the upper surface 1132a of the second layer 1132 may also be provided flat. The light emitting layer 116 may be disposed on the second layer 1132.

Meanwhile, a refractive index of the second layer 1132 may be greater than that of the first layer 1131. Therefore, as shown in FIG. 2, a path of light emitted from a light emitting layer 116 and directed toward the substrate 110 may be changed toward the reflective portion 130 due to a difference in refractive indexes between the second layer 1132 and the first layer 1131 of the light extraction portion 140. Therefore, the light having a path formed in the reflective portion 130 by the light extraction portion 140 may be reflected in the reflective portion 130 and emitted toward the light emission area EA of the subpixel SP for emitting light. Hereinafter, the light reflected in the reflective portion 130 and emitted toward the substrate 110 will be defined as the reflective light.

As shown in FIG. 2, the reflective light may include first reflective light L1 (or WG mode extraction light L1) reflected from the reflective portion 130 and emitted to the substrate 110 after being subjected to optical waveguide through total reflection between the pixel electrode 114 and the reflective electrode 117, second reflective light L2 reflected from the reflective portion 130 and emitted to the substrate 110 after its path is changed by the light extraction portion 140, and third reflective light L3 (or substrate mode extraction light) emitted from the light emitting layer 116, primarily reflected by the reflective portion 130, secondarily reflected on a boundary surface between the lower surface of the substrate 110 and the air layer, thirdly reflected by the reflective portion 130 and then emitted to the substrate 110. The first reflective light L1, the second reflective light L2 and the third reflective light L3, which are shown in solid lines in FIG. 3, may be the reflective light extracted by being reflected by the reflective portion 130.

As shown in FIG. 2, the first reflective light L1 according to one example may be emitted from the light emission area EA. The second reflective light L2 may be emitted from a position spaced apart from the light emission area EA. That is, the second reflective light L2 may be emitted from the non-light emission area NEA or the peripheral area. However, the present disclosure is not limited to the above example. The first reflective light L1 may be emitted toward the substrate 110 from the position spaced apart from the light emission area EA. The third reflective light L3 may be emitted from the light emission area EA or the non-light emission area NEA.

The display apparatus 100 according to one embodiment of the present disclosure may further include light which is emitted to the substrate 110 through the light extraction portion 140 without being reflected by the reflective portion 130. For example, as shown by the dotted line in FIG. 2, the display apparatus 100 may further include primary extraction light L4 emitted from the light emitting layer 116, refracted on a boundary surface between the plurality of concave portions 141 included in the light extraction portion 140 and the first layer 1131 and then emitted to the substrate 110, and recycle light L5 emitted from the light emitting layer 116, primarily refracted on the boundary surface between the plurality of concave portions 141 and the first layer 1131, secondarily reflected on the lower surface of the pixel electrode 114, refracted on the boundary surface between the plurality of concave portions 141 and the first layer 1131 and then emitted to the substrate 110. Therefore, the display apparatus 100 according to one embodiment of the present disclosure may improve the overall light extraction efficiency through the light extraction portion 140 and the reflective portion 130.

In the display apparatus 100 according to one embodiment of the present disclosure, since the pattern portion 120 is disposed to surround the light emission area EA, at least a portion of the reflective portion 130 on the pattern portion 120 may be disposed to surround the light emission area EA. Therefore, the reflective light may be emitted toward the substrate 110 from the position spaced apart from the light emission area EA while surrounding at least a portion of the light emission area EA. Therefore, in the display apparatus 100 according to one embodiment of the present disclosure, since light dissipated by waveguide (or optical waveguide) and/or light dissipated by the interface total reflection may be emitted from the non-light emission area NEA in the form of reflective light through the reflective portion 130 surrounding at least a portion of the light emission area EA, light extraction efficiency may be improved and the overall light emission efficiency may be increased.

Hereinafter, a structure of each of the plurality of subpixels SP will be described in detail.

Referring to FIG. 2, the display apparatus 100 according to one embodiment of the present disclosure may further include a buffer layer BL, a circuit element layer, a thin film transistor (not shown), a pixel electrode 114, a bank 115, a light emitting layer 116, a reflective electrode 117, an encapsulation layer 118 and a color filter CF.

In more detail, each of the subpixels SP according to one embodiment may include a circuit element layer provided on an upper surface of a buffer layer BL, including a gate insulating layer (not shown), an interlayer insulating layer 111 and a passivation layer 112, an overcoat layer 113 provided on the circuit element layer, a pixel electrode 114 provided on the overcoat layer 113, a bank 115 covering an edge of the pixel electrode 114, a light emitting layer 116 on the pixel electrode 114 and the bank 115, a reflective electrode 117 on the light emitting layer 116, and an encapsulation layer 118 on the reflective electrode 117.

The thin film transistor for driving the subpixel SP may be disposed on the circuit element layer. The circuit element layer may be expressed in terms of an inorganic film layer. The pixel electrode 114, the light emitting layer 116 and the reflective electrode 117 may be included in the light emitting element layer E.

The buffer layer BL may be formed between the substrate 110 and the gate insulating layer to protect the thin film transistor. The buffer layer BL may be disposed on the entire surface (or front surface) of the substrate 110. The pixel power line EVDD for pixel driving may be disposed between the buffer layer BL and the passivation layer 112. The buffer layer BL may serve to block diffusion of a material contained in the substrate 110 into a transistor layer during a high temperature process of a manufacturing process of the thin film transistor. Optionally, the buffer layer BL may be omitted in some cases.

The thin film transistor (or a drive transistor) according to an example may include an active layer, a gate electrode, a source electrode, and a drain electrode. The active layer may include a channel area, a drain area and a source area, which are formed in a thin film transistor area of a circuit area of the subpixel SP. The drain area and the source area may be spaced parallel to each other with the channel area interposed therebetween.

The active layer may be formed of a semiconductor material based on any one of amorphous silicon, polycrystalline silicon, oxide and organic material.

The gate insulating layer may be formed on the channel area of the active layer. As an example, the gate insulating layer may be formed in an island shape only on the channel area of the active layer, or may be formed on an entire front surface of the substrate 110 or the buffer layer BL, which includes the active layer.

The gate electrode may be formed on the gate insulating layer to overlap the channel area of the active layer.

The interlayer insulating layer 111 may be formed to partially overlap the gate electrode and the drain area and source area of the active layer. The interlayer insulating layer 111 may be formed over the entire light emission area where light is emitted in the circuit area and the subpixel SP.

The source electrode may be electrically connected to the source area of the active layer through a source contact hole provided in the interlayer insulating layer overlapped with the source area of the active layer. The drain electrode may be electrically connected to the drain area of the active layer through a drain contact hole provided in the interlayer insulating layer 111 overlapped with the drain area of the active layer.

The drain electrode and the source electrode may be made of the same metal material. For example, each of the drain electrode and the source electrode may be made of a single metal layer, a single layer of an alloy or a multi-layer of two or more layers, which is the same as or different from that of the gate electrode.

In addition, the circuit area may further include first and second switching thin film transistors disposed together with the thin film transistor, and a capacitor. Since each of the first and second switching thin film transistors is provided on the circuit area of the subpixel SP to have the same structure as that of the thin film transistor, its description will be omitted. The capacitor (not shown) may be provided in an overlap area between the gate electrode and the source electrode of the thin film transistor, which overlap each other with the interlayer insulating layer 111 interposed therebetween.

Additionally, in order to prevent a threshold voltage of the thin film transistor provided in a pixel area from being shifted by light, the display panel or the substrate 110 may further include a light shielding layer (not shown) provided below the active layer of at least one of the thin film transistor, the first switching thin film transistor or the second switching thin film transistor. The light shielding layer may be disposed between the substrate 110 and the active layer to shield light incident on the active layer through the substrate 110, thereby minimizing a change in the threshold voltage of the transistor due to external light. Also, since the light shielding layer is provided between the substrate 110 and the active layer, the thin film transistor may be prevented from being seen by a user.

The passivation layer 112 may be provided on the substrate 110 to cover the pixel area. The passivation layer 112 covers a drain electrode, a source electrode and a gate electrode of the thin film transistor, and the buffer layer. The reference line may be disposed between the passivation layer 112 and the interlayer insulating layer 111. The reference line may be disposed at a position symmetrical to the pixel power line EVDD based on the light emission area EA or a similar position symmetrical to the pixel power line EVDD. Therefore, the reference line and the pixel power line EVDD may be disposed below the bank 115 without covering the light emitting area EA. The passivation layer 112 may be formed over the circuit area and the light emission area. The passivation layer 112 may be omitted. The color filter CF may be disposed on the passivation layer 112.

The overcoat layer 113 may be provided on the substrate 110 to cover the passivation layer 112 and the color filter CF. When the passivation layer 112 is omitted, the overcoat layer 113 may be provided on the substrate 110 to cover the circuit area. The overcoat layer 113 may be formed in the circuit area in which the thin film transistor is disposed and the light emission area EA. In addition, the overcoat layer 113 may be formed in the other non-display area NDA except a pad area PA of the non-display area NDA and the entire display area DA. For example, the overcoat layer 113 may include an extension portion (or an enlarged portion) extended or enlarged from the display area DA to the other non-display area NDA except the pad area PA. Therefore, the overcoat layer 113 may have a size relatively wider than that of the display area DA.

The overcoat layer 113 according to one example may be formed to have a relatively thick thickness, thereby providing a flat surface on the display area DA and the non-display area NDA. For example, the overcoat layer 113 may be made of an organic material such as photo acryl, benzocyclobutene, polyimide and fluorine resin.

The overcoat layer 113 formed in the display area DA (or the light emission area EA) may include a plurality of concave portions 141. The plurality of concave portions 141 are the elements of the light extraction portion 140 for increasing light efficiency of the light emission area EA, and may be formed inside the overcoat layer 113. In detail, as shown in FIG. 2, the plurality of concave portions 141 may be formed in a concave shape on the first layer 1131 of the overcoat layer 113. The plurality of concave portions 141 are provided to be connected to each other so that an embossed shape may be formed in the first layer 1131.

The second layer 1132 having a refractive index higher than that of the first layer 1131 may be formed on the first layer 1131. A path of the light, which is directed toward the adjacent subpixel SP, among the light emitted from the light emitting element layer E may be changed toward the reflective portion 130 in accordance with a difference in the refractive index between the second layer 1132 and the first layer 1131. The second layer 1132 may be provided to cover the embossed shape of the first layer 1131 and thus the upper surface 1132a may be provided to be flat.

The pixel electrode 114 is formed on the upper surface 1132a of the second layer 1132 so that the pixel electrode 114 may be provided to be flat, and the light emitting layer 116 and the reflective electrode 117, which are formed on the pixel electrode 114, may be provided to be also flat. Since the pixel electrode 114, the light emitting layer 116, the reflective electrode 117, that is, the light emitting element layer E is provided to be flat in the light emission area EA, a thickness of each of the pixel electrode 114, the light emitting layer 116 and the reflective electrode 117 in the light emission area EA may be uniformly formed. Therefore, the light emitting layer 116 may be uniformly emitted without deviation in the light emission area EA.

The plurality of concave portions 141 may be formed on the first layer 1131 through a photo process using a mask having an opening portion and then a pattern (or etching) or ashing process after the first layer 1131 is coated to cover the passivation layer 112 and the color filter CF. The plurality of concave portions 141 may be formed in an area overlapped with the color filter CF and/or an area that is not overlapped with the bank 115 of the non-light emission area NEA, but are not limited thereto. A portion of the plurality of concave portions 141 may be formed to overlap the bank 115.

Referring back to FIG. 2, the color filter CF disposed in the light emission area EA may be provided between the substrate 110 and the overcoat layer 113. Therefore, the color filter CF may be disposed between the pixel power line EVDD, for example, the pixel power line EVDD and the reflective portion 130 or between the pixel driving line and the pattern portion 120. The color filter CF may include a red color filter (or a first color filter) CF1 for converting white light emitted from the light emitting layer 116 into red light, a green color filter (or a second color filter) CF2 for converting white light into green light, and a blue color filter (or a third color filter) CF3 for converting white light into blue light. The fourth subpixel, which is a white subpixel, may not include a color filter since the light emitting layer 116 emits white light.

As shown in FIG. 2, the display apparatus 100 according to one embodiment of the present disclosure may be provided such that color filters having different colors partially overlap each other at a boundary portion of the plurality of subpixels SP. In this case, the display apparatus 100 according to one embodiment of the present disclosure may prevent the light emitted from each subpixel SP from being emitted to the adjacent subpixel SP due to the color filters overlapped with each other at the boundary portion of the subpixels SP, thereby preventing color mixture between the subpixels SP from occurring.

The pixel electrode 114 of the subpixel SP may be formed on the overcoat layer 113. The pixel electrode 114 may be connected to a drain electrode or a source electrode of the thin film transistor through a contact hole passing through the overcoat layer 113 and the passivation layer 112. The edge portion of the pixel electrode 114 may be covered by the bank 115.

Because the display apparatus 100 according to an embodiment of the present disclosure is configured as the bottom emission type, the pixel electrode 114 may be formed of a transparent conductive material (or TCO), such as indium tin oxide (ITO) or indium zinc oxide (IZO) capable of transmitting light, or a semi-transmissive conductive material such as magnesium (Mg), silver (Ag), or an alloy of Mg and Ag.

Meanwhile, the material constituting the pixel electrode 114 may include MoTi. The pixel electrode 114 may be a first electrode or an anode electrode.

The bank 115 is an area from which light is not emitted, and may be provided to surround each of the light emitting portions (or the concave portions 141) of each of the plurality of subpixels SP. That is, the bank 115 may partition (or define) the concave portions 141 of each of the light emitting portion or the subpixels SP. The light emitting portion may mean a portion where the pixel electrode 114 and the reflective electrode 117 are in contact with each of the upper surface and the lower surface of the light emitting layer 116 with the light emitting layer 116 interposed therebetween.

The bank 115 may be formed to cover the edge of each pixel electrode 114 of each of the subpixels SP and expose a portion of each of the pixel electrodes 114. That is, the bank 115 may partially cover the pixel electrode 114. Therefore, the bank 115 may prevent the pixel electrode 114 and the reflective electrode 117 from being in contact with each other at the end of each pixel electrode 114. The exposed portion of the pixel electrode 114, which is not covered by the bank 115, may be included in the light emitting portion (or the light emission area EA). As shown in FIG. 2, the light emitting portion may be formed on the plurality of concave portions 141, and thus the light emitting portion (or the light emission area EA) may overlap the concave portions 141 in a thickness direction (or the third direction (Z-axis direction)) of the substrate 110.

After the bank 115 is formed, the light emitting layer 116 may be formed to cover the pixel electrode 114 and the bank 115. Therefore, the bank 115 may be provided between the pixel electrode 114 and the light emitting layer 116. The bank 115 may be expressed as the term of a pixel defining layer. The bank 115 according to one example may include an organic material and/or an inorganic material. As shown in FIG. 2, the bank 115 may be formed to be concave or inclined along the profile of the pattern portion 120 (or the second layer 1132).

Referring again to FIG. 2, the light emitting layer 116 may be formed on the pixel electrode 114 and the bank 115. The light emitting layer 116 may be provided between the pixel electrode 114 and the reflective electrode 117. Thus, when a voltage is applied to each of the pixel electrode 114 and the reflective electrode 117, an electric field is formed between the pixel electrode 114 and the reflective electrode 117. Therefore, the light emitting layer 116 may emit light. The light emitting layer 116 may be formed of a plurality of subpixels SP and a common layer provided on the bank 115.

The light emitting layer 116 according to an embodiment may be provided to emit white light. The light emitting layer 116 may include a plurality of stacks which emit lights of different colors. For example, the light emitting layer 116 may include a first stack, a second stack, and a charge generating layer (CGL) provided between the first stack and the second stack. The light emitting layer may be provided to emit the white light, and thus, each of the plurality of subpixels SP may include a color filter CF suitable for a corresponding color.

The first stack may be provided on the pixel electrode 114 and may be implemented a structure where a hole injection layer (HIL), a hole transport layer (HTL), an emission layer (EML(B)), and an electron transport layer (ETL) are sequentially stacked.

The charge generating layer may supply an electric charge to the first stack and the second stack. The charge generating layer may include an N-type charge generating layer for supplying an electron to the first stack and a P-type charge generating layer for supplying a hole to the second stack. The N-type charge generating layer may include a metal material as a dopant.

The second stack may be provided on the first stack and may be implemented in a structure where a hole transport layer (HTL), a yellow-green (YG) emission layer (EML(YG)), and an electron injection layer (EIL) are sequentially stacked.

In the display apparatus 100 according to an embodiment of the present disclosure, because the light emitting layer 116 is provided as a common layer, the first stack, the charge generating layer, and the second stack may be arranged all over the plurality of subpixels SP.

The reflective electrode 117 may be formed on the light emitting layer 116. The reflective electrode 117 may be disposed in the light emission area EA and the non-light emission area NEA. The reflective electrode 117 according to one example may include a metal material. The reflective electrode 117 may reflect the light emitted from the light emitting layer 116 in the plurality of subpixels SP toward the lower surface of the substrate 110. Therefore, the display apparatus 100 according to one embodiment of the present disclosure may be implemented as a bottom emission type display apparatus.

The display apparatus 100 according to one embodiment of the present disclosure is a bottom emission type and has to reflect light emitted from the light emitting layer 116 toward the substrate 110, and thus the reflective electrode 117 may be made of a metal material having high reflectance. The reflective electrode 117 according to one example may be formed of a metal material having high reflectance such as a stacked structure (Ti/Al/Ti) of aluminum and titanium, a stacked structure (ITO/Al/ITO) of aluminum and ITO, an Ag alloy and a stacked structure (ITO/Ag alloy/ITO) of Ag alloy and ITO. The Ag alloy may be an alloy such as silver (Ag), palladium (Pd) and copper (Cu). The reflective electrode 117 may be expressed as terms such as a second electrode, a cathode electrode and a counter electrode.

Meanwhile, in the display apparatus 100 according to one embodiment of the present disclosure, the reflective portion 130 may be a portion of the reflective electrode 117. Therefore, the reflective portion 130 may reflect light, which is directed toward the adjacent subpixel SP, toward the light emission area EA of the subpixel SP for emitting light. Since the reflective portion 130 is a portion of the reflective electrode 117, as shown in FIG. 2, the reflective portion 130 may be denoted by a reference numeral 117a. In the present disclosure, the reflective portion 130 may mean the reflective electrode 117 that overlaps the pattern portion 120. In particular, the reflective portion 130 may mean the reflective electrode 117 that is inclined while being overlapped with the pattern portion 120. Therefore, as shown in FIG. 3, the reflective portion 130 may reflect light that is directed toward the adjacent subpixel SP, or light that is dissipated through total reflection between interfaces, toward the light emission area EA (or the non-light emission area NEA) of the subpixel SP for emitting light.

The encapsulation layer 118 is formed on the reflective electrode 117. The encapsulation layer 118 serves to prevent oxygen or moisture from being permeated into the light emitting layer 116 and the reflective electrode 117. To this end, the encapsulation layer 118 may include at least one inorganic film and at least one organic film.

Meanwhile, as shown in FIG. 2, the encapsulation layer 118 may be disposed not only in the light emission area EA but also in the non-light emission area NEA. The encapsulation layer 118 may be disposed between the reflective electrode 117 and an opposing substrate 200.

Hereinafter, the pattern portion 120 and the reflective portion 130 of the display apparatus 100 according to one embodiment of the present disclosure will be described in more detail with reference to FIGS. 2 and 3.

In the display apparatus 100 according to one embodiment of the present disclosure, the pattern portion 120 may be provided near the light emission area EA (or the non-light emission area NEA) and the reflective portion 130 may be provided on the pattern portion 120 in order to prevent light extraction efficiency from being reduced as some of the light emitted from the light emitting element layer is not discharged to the outside due to total reflection on an interface between the light emitting element layer and the electrode and/or an interface between the substrate and the air layer. The reflective portion 130 may be disposed to be inclined along the profile of the pattern portion 120. Also, as the inclination angle θ of the reflective portion 130 is provided at an optimal angle in dependency on the maximum thickness of the second layer 1132 and the thickness of the first layer 1131, light extraction efficiency may be improved without parasitic capacitance.

Referring to FIG. 2, the pattern portion 120 may be formed to be concave in the first layer 1131 of the overcoat layer 113. As shown in FIG. 2, the pattern portion 120 may be disposed near the non-light emission area NEA. That is, the pattern portion 120 may be disposed to surround the light emission area EA while being adjacent to the light extraction portion 140. The pattern portion 120 may be formed in the non-light emission area NEA together with the plurality of concave portions 141 when the plurality of concave portions 141 are formed in the light emission area EA. The pattern portion 120 may include a bottom surface 120b and an inclined surface 120s.

The bottom surface 120b of the pattern portion 120 according to one embodiment is a surface formed to be closest to the substrate 110, or may be disposed to be closer to the substrate 110 (or the upper surface of the substrate) than the pixel electrode 114 (or the lower surface of the pixel electrode 114) in the light emission area EA. Therefore, as shown in FIG. 3, the bottom surface 120b of the pattern portion 120 may be provided to have a depth equal to or similar to that of each of the plurality of concave portions 141. However, when the depth of the pattern portion 120 is lower than that of the concave portion 141, since an area of the reflective portion 130 is reduced, light extraction efficiency may be reduced. Therefore, in the display apparatus 100 according to one embodiment of the present disclosure, the depth of the pattern portion 120 may be provided to be equal to or deeper than that of the concave portion 141.

The inclined surface 120s of the pattern portion 120 may be disposed between the bottom surface 120b and the light extraction portion 140. Therefore, the inclined surface 120s of the pattern portion 120 may be provided to surround the light emission area EA or the plurality of concave portions 141. As shown in FIG. 2, the inclined surface 120s may be connected to the bottom surface 120b. The inclined surface 120s may form a predetermined angle with the bottom surface 120b. For example, the angle formed by the inclined surface 120s and the bottom surface 120b may be an obtuse angle. Therefore, a width of the pattern portion 120 may be gradually reduced toward a direction (or the third direction (Z-axis direction)) from the opposing substrate 200 (or the reflective portion 130) toward the substrate 110. As the obtuse angle is formed by the inclined surface 120s and the bottom surface 120b, the light emitting element layer E (or the light emitting element layer E including the reflective portion 130) including the second layer 1132, the bank 115 and the reflective portion 130, which are formed in a subsequent process, may be formed to be concave along the profile of the pattern portion 120. Therefore, the light emitting element layer E may be formed to be concave on the pattern portion 120 formed to be concave in the non-light emission area NEA (or the peripheral area). The light emitting element layer E formed to be concave in the pattern portion 120 may mean that it includes at least one of the pixel electrode 114, the light emitting layer 116 or the reflective electrode 117.

As shown in FIG. 2, the pattern portion 120 may be provided to surround the light emission area EA. As the pattern portion 120 is provided to surround the light emission area EA, at least a portion of the reflective portion 130 disposed to be inclined on the pattern portion 120 may be provided to surround the light emission area EA. Therefore, in the display apparatus 100 according to one embodiment of the present disclosure, since light may be extracted even from the non-light emission area NEA near the light emission area EA, overall light efficiency may be improved. Therefore, the display apparatus 100 according to one embodiment of the present disclosure may have the same light emission efficiency or more improved light emission efficiency even with low power as compared with a general display apparatus having no pattern portion 120 and reflective portion 130, whereby overall power consumption may be reduced.

In addition, the display apparatus 100 according to one embodiment of the present disclosure may allow the light emitting element layer E to emit light even with low power, thereby improving lifespan of the light emitting element layer E.

Since the pattern portion 120 is disposed to surround the light emission area EA, the pattern portion 120 may be disposed between the subpixels SP for emitting light of different colors. Therefore, the reflective portion 130 disposed to be inclined on the pattern portion 120 may be disposed between the subpixels SP for emitting light of different colors, whereby the reflective portion 130 may prevent light of different colors from being emitted to other adjacent subpixels SP. Therefore, the display apparatus 100 according to the present disclosure may prevent color mixture (or color distortion) from occurring between the subpixels SP for emitting light of different colors, thereby improving color purity.

The second layer 1132 of the overcoat layer 113 may be further extended from the light emission area EA to the non-light emission area NEA to partially cover the inclined surface 120s of the pattern portion 120. Therefore, as shown in FIG. 3, an end 1132c of the second layer 1132 may be in contact with the bottom surface 120b of the pattern portion 120. In this case, the end 1132c of the second layer 1132 may be in contact with only a portion of the bottom surface 120b. When the second layer 1132 entirely covers the bottom surface 120b, the depth of the reflective portion 130 formed on the pattern portion 120 may be relatively lowered, thereby reducing reflective efficiency. Therefore, in the display apparatus 100 according to one embodiment of the present disclosure, the second layer 1132 is provided to be in contact with only a portion of the bottom surface 120b without entirely covering the bottom surface 120b of the pattern portion 120 and thus the reflective portion 130 formed in a subsequent process may be formed to be close to the bottom surface 120b, whereby reflective efficiency may be improved.

The bank 115 may be extended to cover the inclined surface 1132b of the second layer 1132 covering the inclined surface 120s of the pattern portion 120 while covering the edge of the pixel electrode 114. Therefore, the bank 115 may be in contact with a portion of the bottom surface 120b of the pattern portion 120, which is not covered by the second layer 1132. When the bank 115 entirely covers the bottom surface 120b, the depth of the reflective portion 130 formed on the pattern portion 120 is lowered, whereby reflective efficiency may be reduced. Therefore, as shown in FIG. 3, each of the second layer 1132 and the bank 115 on the bottom surface 120b of the pattern portion 120 may be discontinuously provided. That is, each of the second layer 1132 and the bank 115 may be disconnected on the bottom surface 120b of the pattern portion 120. As a result, in the display apparatus 100 according to one embodiment of the present disclosure, the bank 115 is provided to be in contact with only a portion of the bottom surface 120b without entirely covering the bottom surface 120b, so that the reflective portion 130 formed in a subsequent process may be formed to be close to the bottom surface 120b, whereby reflective efficiency may be improved.

Since the bank 115 is provided to be in contact with only a portion of the bottom surface 120b of the pattern portion 120, the bank 115 may be disconnected from the pattern portion 120 as shown in FIG. 2. As the bank 115 is disconnected from the pattern portion 120, the reflective portion 130 disposed on the second pattern line 122 may be disposed to be close to the bottom surface 120b of the pattern portion 120. Therefore, the reflective portion 130 may be formed as deep as possible in the pattern portion 120 as compared with the case that the bank is not disconnected from the pattern portion 120, and thus reflective efficiency may be improved. As shown in FIG. 2, since the pattern portion 120 is disposed between the subpixels SP, the second layer 1132, the bank 115, the light emitting layer 116 and the reflective portion 130 may be provided to be symmetrical based on the center of the pattern portion 120 (or the center of the second area A2).

In the display apparatus 100 according to one embodiment of the present disclosure, the plurality of lines 150 may be disposed so as not to cover the light emission area EA (or so as not to overlap the light emission area EA). When the plurality of lines 150 overlap or cover the light emission area EA, the light reflected by the reflective portion 130 may be blocked by the plurality of lines 150 and thus cannot be emitted toward the substrate 110. Therefore, in the display apparatus 100 according to one embodiment of the present disclosure, the plurality of lines 150 may be disposed in the non-light emission area NEA so as not to overlap the light emission area EA, whereby light extraction efficiency may be maximized. Also, in the display apparatus 100 according to one embodiment of the present disclosure, the plurality of lines 150 may be provided so as not to overlap the light emission area EA, whereby an aperture ratio may be enlarged as compared with the case that the plurality of lines overlap the light emission area, and thus luminance may be improved. Although the arrangement structure of the plurality of lines 150 in the first subpixel SP1 and the second subpixel SP2 has been described with reference to FIG. 2, the above-described structure may be equally applied to the third subpixel SP3 and the fourth subpixel SP4. However, a line having a wide width, which is disposed among the first to fourth subpixels may be the reference line.

Meanwhile, as the bank 115 is disconnected from the pattern portion 120, the light emitting layer 116 and the reflective portion 130 (or the reflective electrode 117) formed in a subsequent process may be formed along a profile of the bottom surface 120b of the pattern portion 120 and the bank 115.

The reflective portion 130 according to one example may be formed to be concave on the pattern portion 120 along the profile of the pattern portion 120 formed to be concave near the non-light emission area NEA, thereby being formed to be concave near the non-light emission area NEA. The reflective portion 130 may be made of a material capable of reflecting light to reflect light, which is emitted from the light emission area EA and directed toward the subpixel SP adjacent thereto, toward the light emission area EA of the subpixel SP for emitting light. As shown in FIG. 2, the reflective portion 130 may include a flat reflective surface 131 disposed at a central portion of the second area A2 and an inclined reflective surface 132 connected to the flat reflective surface 131. The flat reflective surface 131 may be disposed in parallel with the bottom surface 120b (shown in FIG. 2) of the pattern portion 120. The inclined reflective surface 132 may be formed to be inclined along the profile of the inclined surface 120s of the pattern portion 120. Most of the light, which is directed toward the subpixel SP adjacent thereto among the light emitted from the subpixel SP for emitting light, may be reflected by the inclined reflective surface 132 of the reflective portion 130 and then emitted to the light emission area EA of the subpixel SP for emitting light or the non-light emission area NEA of the subpixel SP for emitting light.

In the display apparatus 100 according to one embodiment of the present disclosure, the inclination angle θ of the reflective portion 130 disposed to be inclined in the non-light emission area NEA may be optimized, whereby parasitic capacitance between the reflective portion 130 and the line 150 may be avoided and overall light efficiency (or light extraction efficiency) of the subpixel SP for emitting light may be improved. The inclination angle θ of the reflective portion 130 may be derived by an equation related to the maximum thickness $T_H$ of the second layer 1132 and the thickness $T_L$ of the first layer 1131 in the concave portion 141.

For example, the inclination angle θ of the reflective portion disposed to be inclined on the pattern portion 120 may be provided to satisfy

$$\text{Taper Angle}(\theta) = \frac{180 \times \log \sqrt{0.11 \times T_L^2 + T_H^2}}{\pi}.$$

$T_H$ may be the maximum thickness of the second layer 1132 in each of the concave portions 141, $T_L$ may be the thickness of the first layer 1131 on an extension line of $T_H$ and $\pi$ may be a circular constant.

As shown in FIG. 3, $T_H$ may be a value (or multiplied value) obtained by multiplying an aspect ratio AR of the concave portion 141 and a radius R of the concave portion 141.

The radius R of the concave portion 141 according to one example may be a distance from a center C of the concave portion 141 on an extension line of a flat upper surface 1131a of the first layer 1131 to the concave portion adjacent thereto.

The aspect ratio AR of the concave portion 141 according to one example is related to a shape of the concave portion 141. For example, the aspect ratio AR of the concave portion 141 may be provided to exceed 0 and be 1 or less. That is, the aspect ratio AR of the concave portion 141 may be provided to satisfy an equation of $0 < AR \leq 1$. When the aspect ratio AR of the concave portion 141 is 1, the concave portion 141 may have a complete hemispherical shape. When the aspect ratio AR of the concave portion 141 is 0, the concave portion 141 may have a flat shape. Therefore, the case that the aspect ratio AR of the concave portion 141 exceeds 0 and is 1 or less may mean that the concave portion 141 may have a complete hemispherical shape or a hemispherical shape between the complete hemispherical shape and a flat shape. For example, when the aspect ratio AR of the concave portion 141 is less than 1, the maximum thickness (or maximum depth) of the concave portion 141 in FIG. 3 may be smaller than the radius R. When the aspect ratio AR of the concave portion 141 is 1, the maximum thickness (or the maximum depth) of the concave portion 141 in FIG. 3 may be equal to the radius R.

Referring back to FIG. 3, $T_L$ may be the thickness of the first layer 1131 on the extension line of $T_H$. That is, the thickness $T_L$ of the first layer 1131 may be a distance from the upper surface 1131a of the first layer 1131 at the maximum thickness $T_H$ (or maximum depth) of the concave portion 141 to the upper surface of the color filter CF. Alternatively, the thickness $T_L$ of the first layer 1131 may be the shortest distance of the first layer 1131 disposed below the concave portion 141.

'π' is a circular constant, and may be about 3.14.

Meanwhile, in the display apparatus 100 according to one embodiment of the present disclosure, a value obtained by adding the maximum thickness $T_H$ of the second layer 1132 in the concave portion 141 and the thickness $T_L$ of the first layer 1131 on the extension line of $T_H$ may be 2 $\mu$m to 7 $\mu$m.

In addition, the radius R of each of the concave portions 141 or the thickness $T_L$ of the first layer 1131 may be 1 $\mu$m or more. When the maximum value of the aspect ratio AR of the concave portion 141 is 1, the aspect ratio AR of the concave portion 141 is equal to the radius R of the concave portion 141. Therefore, when the aspect ratio AR of the concave portion 141 is 1 and the radius R of the concave portion 141 is 1 $\mu$m, the maximum thickness $T_H$ of the second layer 1132 may be 1 $\mu$m. In this case, the thickness $T_L$ of the first layer 1131 on the extension line of $T_H$ may be 1 $\mu$m

or more. Therefore, a value obtained by summing the maximum thickness $T_H$ of the second layer 1132 in the concave portion 141 and the thickness $T_L$ of the first layer 1131 on the extension line of $T_H$ may be 2 $\mu$m or more. The radius R of the concave portion 141 or the thickness $T_L$ of the first layer 1131 cannot be formed to be less than 1 $\mu$m due to limitation in a process. This is because that the concave portion 141 is not formed in a photo process and a pattern (or etching) or ashing process after the photo process when the thickness of the first layer 1131 is less than 1 $\mu$m.

Therefore, in the display apparatus 100 according to one embodiment of the present disclosure, as the radius R of each of the concave portions 141 or the thickness $T_L$ of the first layer 1131 is provided to be 1 $\mu$m or more, the concave portion 141 for refracting light without limitation in a process may be formed on the first layer 1131.

Meanwhile, when the sum of the maximum thickness $T_H$ of the second layer 1132 in the concave portion 141 and the thickness $T_L$ of the first layer 1131 on the extension line of $T_H$ is less than 2 $\mu$m, the inclination angle $\theta$ of the reflective portion 130 is too low (or reduced), whereby reflectivity of the light directed toward the adjacent subpixel SP may be deteriorated.

The value obtained by summing the maximum thickness $T_H$ of the second layer 1132 in the concave portion 141 and the thickness $T_L$ of the first layer 1131 on the extension line of $T_H$ may be 7 $\mu$m or less by limitation in a process. The first layer 1131 or the second layer 1132 should be formed once more so that the sum of the maximum thickness $T_H$ of the second layer 1132 in the concave portion 141 and the thickness $T_L$ of the first layer 1131 on the extension line of $T_H$ exceeds 7 $\mu$m. In this case, steps in the process may be increased, whereby a tact time and a manufacturing cost may be increased.

Therefore, in the display apparatus 100 according to one embodiment of the present disclosure, the value obtained by summing the maximum thickness $T_H$ of the second layer 1132 in the concave portion 141 and the thickness $T_L$ of the first layer 1131 on the extension line of $T_H$ may be 2 $\mu$m to 7 $\mu$m, whereby reflectance of the light directed toward the adjacent subpixel SP may be prevented from being deteriorated, and the tact time and the manufacturing cost may be prevented from being increased.

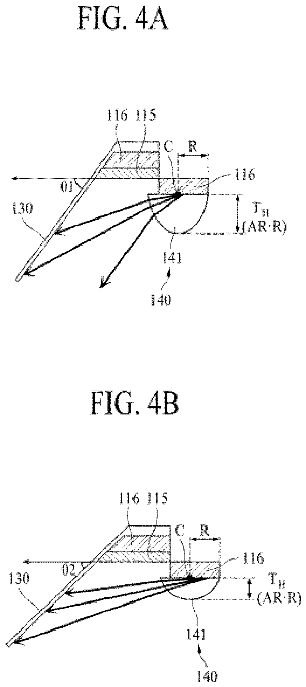

Hereinafter, the aspect ratio AR of the concave portion 141 and the inclination angle $\theta$ of the reflective portion 130 will be described with reference to FIGS. 4a and 4b.

FIG. 4a is a comparative example illustrating that an aspect ratio of a concave portion exceeds 1, and FIG. 4b is a view illustrating that an aspect ratio of a concave portion of a display apparatus according to one embodiment of the present disclosure exceeds 0 and is less than 1.

As shown in FIG. 4a, when the aspect ratio AR of the concave portion 141 exceeds 1, the concave portion 141 may have a bell shape other than a complete hemispherical shape. That is, the maximum depth $T_H$ of the concave portion 141 may be greater than the radius R of the concave portion 141.

Meanwhile, as shown in FIG. 4a, when light incident from a right side based on the center C of the concave portion 141 is emitted from the concave portion 141, the light may be emitted by being bent downward due to a difference in refractive index from the first layer. In case of FIG. 4a, since the concave portion 141 has a bell shape, an angle bent by the difference in refractive index may be greater in a downward direction. Therefore, as shown in FIG. 4a, when the aspect ratio AR of the concave portion 141 exceeds 1, a portion of the light emitted through the concave portion 141 may be emitted toward the adjacent subpixel without being reflected by the reflective portion 130 even though an inclination angle $\theta 1$ of the reflective portion 130 is great. Therefore, in case of FIG. 4a, color mixture may be generated between the subpixel for emitting light and the adjacent subpixel.

On the contrary, in case of FIG. 4b, since the aspect ratio AR of the concave portion 141 exceeds 0 and is less than 1, the concave portion 141 may have a bowl shape having a wider width than the depth. That is, the maximum depth $T_H$ of the concave portion 141 may be smaller than the radius R of the concave portion 141.

In this case, when light incident from the right side based on the center C of the concave portion 141 is emitted from the concave portion 141 as shown in FIG. 4b, the light may be emitted by being bent downward due to the difference in refractive index from the first layer. However, in case of FIG. 4b, since the concave portion 141 has a bowl shape, an angle bent due to the difference in refractive index may not be greater than that of FIG. 4a even though the concave portion 141 moves downward. Therefore, as shown in FIG. 4b, when the aspect ratio AR of the concave portion 141 exceeds 0 and is less than 1, the light emitted through the concave portion 141 may be reflected by the reflective portion 130 and then emitted toward the subpixel for emitting light even though an inclination angle $\theta 2$ of the reflective portion 130 is smaller than the inclination angle $\theta 1$ of the reflective portion 130 of FIG. 4a. Therefore, in case of 4b, light extraction efficiency (or light efficiency) of the subpixel for emitting light may be improved without color mixture between the subpixel for emitting light and the adjacent subpixel.

As a result, in the display apparatus 100 according to one embodiment of the present disclosure, the inclination angle of the reflective portion 130 may correspond to or may be proportional to the aspect ratio AR of each of the concave portions 141. Meanwhile, when the aspect ratio AR of the concave portion 141 is 0, the concave portion 141 is provided in a flat shape so that light is not refracted in a predetermined direction and thus light efficiency may be rather deteriorated. Therefore, in the display apparatus 100 according to one embodiment of the present disclosure, the aspect ratio AR of the concave portion 141 may exceed 0 and be 1 or less, and thus the inclination angle of the reflective portion 130 may be 40° to 75°, correspondingly or proportionally. As a result, the display apparatus 100 according to one embodiment of the present disclosure may improve light extraction efficiency (or light efficiency) of the subpixel for emitting light while preventing color mixture from occurring between the subpixel for emitting light and the adjacent subpixel.

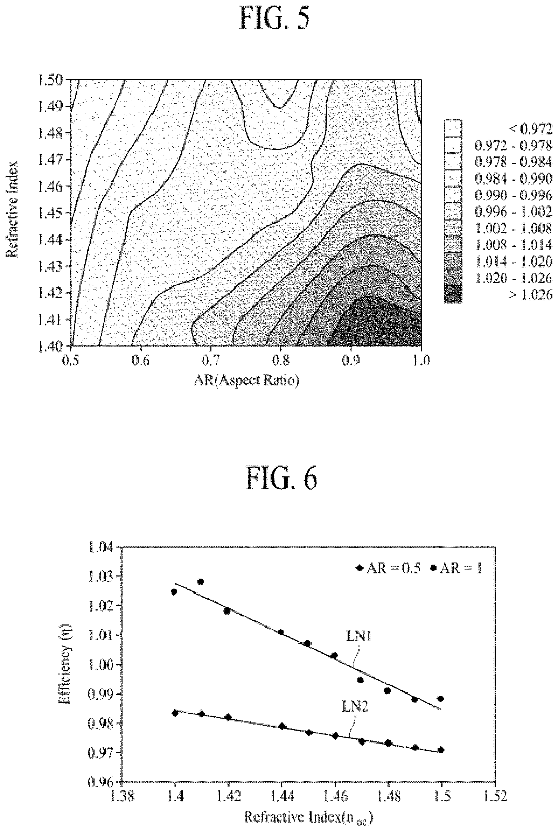

FIG. 5 is a light efficiency map illustrating a refractive index of a concave portion with respect to an aspect ratio of the concave portion of a display apparatus according to one embodiment of the present disclosure.

Referring to FIG. 5, a horizontal axis represents the aspect ratio AR of the concave portion 141, and a vertical axis represents the refractive index of the first layer 1131. FIG. 5 is a light efficiency map illustrating the refractive index of the first layer 1131 according to the aspect ratio AR of the concave portion 141 in a state that the refractive index of the second layer 1132 is fixed. For example, the inventor of the display apparatus of the present disclosure measured light efficiency while changing each of the aspect ratio AR of the concave portion 141 and the refractive index of the first layer 1131 in a state that the refractive index of the second layer 1132 is fixed to 1.63. As shown in FIG. 5, it can be seen that when the aspect ratio AR of the concave portion 141 is great and the refractive index of the first layer 1131 is low, shade representing light efficiency becomes dark. It can be seen that light efficiency is increased to 1.0 or more as the shade becomes dark. As shown in FIG. 5, it can be seen that when the aspect ratio AR of the concave portion 141 is 1 and the refractive index of the first layer 1131 is 1.40, shade is the darkest in the light efficiency map and light efficiency exceeds 1.026. Therefore, the display apparatus 100 according to one embodiment of the present disclosure may maximize light extraction efficiency (or light efficiency) as the aspect ratio AR of the concave portion 141 is 1 and the difference in refractive index between the second layer 1132 and the first layer 1131 is 0.23 or more.

FIG. 6 is a graph illustrating light efficiency with respect to a refractive index of a first layer of a display apparatus according to one embodiment of the present disclosure.

Referring to FIG. 6, a horizontal axis represents a refractive index $n_{oc}$ of the first layer 1131, and a vertical axis represents a light efficiency $\eta$. In this case, LN1 represents light efficiency with respect to the refractive index $n_{oc}$ of the first layer 1131 when the aspect ratio AR of the concave portion 141 is 1. When the aspect ratio AR of the concave portion 141 is 1, the concave portion 141 has a complete hemispherical shape, and the maximum depth $T_H$ of the concave portion 141 and the radius of the concave portion 141 may be the same as each other. LN2 represents light efficiency for the refractive index $n_{oc}$ of the first layer 1131 when the aspect ratio AR of the concave portion 141 is 0.5. As shown in FIG. 6, it can be seen that even though the refractive index $n_{oc}$ of the first layer 1131 is increased, light efficiency of LN1 is higher than that of LN2. That is, it can be seen that the greater the aspect ratio of the concave portion 141 is, the higher light efficiency is. For example, as shown in FIG. 6, when the refractive index $n_{oc}$ of the first layer 1131 is 1.4, since LN1 represents light efficiency of about 1.025 and LN2 represents light efficiency of about 0.983, it can be seen that light efficiency of LN1 is higher than that of LN2 as much as about 0.042. In addition, when the refractive index $n_{oc}$ of the first layer 1131 is 1.5, since LN1 represents light efficiency of about 0.987 and LN2 represents light efficiency of about 0.972, it can be seen that light efficiency of LN1 is higher than that of LN2 as much as about 0.015.

However, as described above, when the aspect ratio AR of the concave portion 141 exceeds 1, the concave portion 141 may have a bell shape and the maximum depth $T_H$ of the concave portion 141 may be greater than the radius R of the concave portion 141. In this case, even though the inclination angle $\theta1$ of the reflective portion 130 is great, a portion of the light emitted through the concave portion 141 may be emitted toward the adjacent subpixel without being reflected by the reflective portion 130, whereby color mixture may be generated between the subpixel for emitting light and the adjacent subpixel.

Therefore, in the display apparatus 100 according to one embodiment of the present disclosure, the aspect ratio AR of the concave portion 141 is 1 and the difference in refractive index between the second layer 1132 and the first layer 1131 is 0.23 or more, whereby color mixture between the subpixel for emitting light and the adjacent subpixel may be avoided and light extraction efficiency (or light efficiency) may be maximized.

According to the present disclosure, the following advantageous effects may be obtained.

In the display apparatus according to the present disclosure, the reflective portion disposed in the non-light-emission area may be provided at an optimal angle, whereby light extraction efficiency in the non-light emission area may be improved and thus overall light efficiency may be improved.

In the display apparatus according to the present disclosure, since the light may be extracted even from the non-light emission area, the display apparatus according to the present disclosure may have the same light emission efficiency or more improved light emission efficiency even with low power as compared with the display apparatus having no reflective portion, whereby overall power consumption may be reduced.

In the display apparatus according to the present disclosure, each of the plurality of subpixels includes the light extraction portion that includes the plurality of concave portions, so that light extraction efficiency of the light emitted from the light emitting element layer may be maximized.

**Claims**

1. A display apparatus comprising:

   a substrate (110) having a plurality of subpixels (SP), each subpixel (SP) including a light emission area (EA) and a non-light emission area (NEA);
   an overcoat layer (113) disposed on the substrate (110), the overcoat layer (113) including a first layer (1131) and a second layer (1132) disposed on the first layer (1131);
   a pattern portion (120) formed in the first layer (1131) in the non-light emission area (NEA) to be concave, the pattern portion (120) including an inclined surface (120s); and
   a reflective portion (130) disposed on the pattern portion (120) in the non-light emission area (NEA) and including an inclined reflective surface (132) on the inclined surface (120s) of the pattern portion (120),
   wherein in the light emission area (EA), the first layer (1131) includes a plurality of concave portions (141) filled by the second layer (1132), and
   wherein an inclination angle θ of the inclined reflective surface (132) of the reflective portion (130) with respect to the substrate (110) is a function of a maximum thickness of the second layer (1132) and a thickness of the first layer (1131) along a center line of one of the concave portions (141).

2. The display apparatus of claim 1, wherein the inclination angle θ of the inclined reflective surface (132) satisfies the equation

$$\text{Taper Angle}(\theta) = \frac{180 \times \log \sqrt{0.11 \times T_L^2 + T_H^2}}{\pi},$$

   wherein $T_H$ is the maximum thickness of the second layer (1132) in the concave portion (141), $T_L$ is the thickness of the first layer (1131) and π is a circular constant.

3. The display apparatus of claim 1 or 2, wherein the inclination angle of the inclined reflective surface (132) is in a range from 40° to 75°.

4. The display apparatus according to any one of the preceding claims, wherein the pattern portion (120) surrounds the light emission areas (EA) of the subpixels (SP) and/or is disposed to be spaced apart from the light emission areas (EA).

5. The display apparatus according to any one of the preceding claims, further comprising a light emitting element layer (E) on the overcoat layer (113) in the plurality of subpixels (SP), wherein the light emitting element layer (E) includes:

   a pixel electrode (114) in the light emission area (EA) of each subpixel (SP);
   a light emitting layer (116) on the pixel electrode (114) in the light emission area (EA) and on the pattern portion (120) in the non-light emission area (NEA); and
   a reflective electrode (118) on the light emitting layer (116) in the light emission area (EA) and the non-light emission area (NEA),
   wherein the reflective portion (130) is a portion of the reflective electrode (117).

6. The display apparatus of claim 5, wherein the inclination angle θ of the inclined reflective surface (132) is an angle between an extension line of a lower surface of the reflective electrode (118) in the light emission area (EA) and the inclined reflective surface (132) of the reflective portion (130) arranged in the non-light emission area (NEA).

7. The display apparatus according to any one of the preceding claims, wherein a value obtained by summing the maximum thickness $T_H$ of the second layer (1132) and the thickness $T_L$ of the first layer (1131) is in a range from 2 μm to 7 μm, and/or
   ^ wherein a radius R of one of the concave portions (141) and/or the thickness $T_L$ of the first layer (1131) is 1 μm or more.

8. The display apparatus according to any one of the preceding claims, wherein the inclination angle θ of the inclined reflective surface (132) of the reflective portion (130) is proportional to or a function of an aspect ratio of one of the concave portions (141.

9. The display apparatus according to any one of the preceding claims, wherein the thickness $T_H$ of the second layer (1132) is a value obtained by multiplying an aspect ratio of one of the concave portions (141) and a radius R of said one of the concave portions (141).

10. The display apparatus according to any one of the preceding claims, wherein an aspect ratio of one of the concave portions (141) is larger than 0 and equal to or less than 1.

11. The display apparatus according to any one of the preceding claims, wherein the non-light emission area (NEA) includes a first area (A1) adjacent to the light emission area (EA) and a second area (A2) adjacent to the first area (A1) and spaced apart from the light emission area (EA), and
the inclined surface (120s) of the pattern portion (120) is formed in the first area (A1) and the pattern portion (120) further includes a bottom surface (120b) in the second area (A2), the bottom surface (120b) extending from the inclined surface (120s).

12. The display apparatus of claim 11, wherein the second layer (1132) extends from the light emission area (EA) into the first area (A1) of the non-light emission area (NEA) to cover the inclined surface (120s) of the pattern portion (120) and to be in contact with the bottom surface (120b) of the pattern portion (120).

13. The display apparatus of claim 11 or 12, wherein the inclined surface (120s) of the pattern portion (120) forms an obtuse angle with respect to the bottom surface (120b).

14. The display apparatus of claim 11, 12 or 13 in combination with claim 5, further comprising a bank (115) covering an edge of the pixel electrode (114),
wherein the bank (115) covers the second layer (1132) on the inclined surface (120s) of the pattern portion (120) and is in contact with a portion of the bottom surface (120b) of the pattern portion (120).

15. The display apparatus of claim 14, wherein each of the second layer (1132) and the bank (115) is discontinuous on the substrate (110).

# FIG. 1

# FIG. 2

# FIG. 3

## FIG. 4A

## FIG. 4B

# FIG. 5

# FIG. 6

Europäisches
Patentamt

European
Patent Office

Office européen
des brevets

# EUROPEAN SEARCH REPORT

Application Number

EP 23 19 9398

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/103587 A1 (LEE KANG-JU [KR] ET AL) 4 April 2019 (2019-04-04) * claims 1-12; figures 1, 3 * | 1-15 | INV. H10K59/122 H10K59/124 H10K59/80 |
| X | US 2019/103442 A1 (CHOI YONG-HOON [KR] ET AL) 4 April 2019 (2019-04-04) * claims 1-20; figures 1-4 * | 1-15 | |
| A | US 2007/290607 A1 (OKADA NAOTADA [JP] ET AL) 20 December 2007 (2007-12-20) * the whole document * | 1-15 | |

TECHNICAL FIELDS SEARCHED (IPC)

H10K

The present search report has been drawn up for all claims

| Place of search | Date of completion of the search | Examiner |
|---|---|---|
| The Hague | 22 February 2024 | Parashkov, Radoslav |

EPO FORM 1503 03.82 (P04C01)

## ANNEX TO THE EUROPEAN SEARCH REPORT
## ON EUROPEAN PATENT APPLICATION NO.

EP 23 19 9398

22-02-2024

| Patent document cited in search report | | Publication date | Patent family member(s) | | Publication date |
|---|---|---|---|---|---|
| US 2019103587 | A1 | 04-04-2019 | CN | 109585671 A | 05-04-2019 |
| | | | KR | 20190037603 A | 08-04-2019 |
| | | | US | 2019103587 A1 | 04-04-2019 |
| US 2019103442 | A1 | 04-04-2019 | CN | 109585672 A | 05-04-2019 |
| | | | US | 2019103442 A1 | 04-04-2019 |
| US 2007290607 | A1 | 20-12-2007 | KR | 20070049211 A | 10-05-2007 |
| | | | TW | I278250 B | 01-04-2007 |
| | | | US | 2007290607 A1 | 20-12-2007 |
| | | | WO | 2006035811 A1 | 06-04-2006 |

EPO FORM P0459

**EP 4 395 506 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220190860